Europäisches Patentamt

European Patent Office

Office européen des brevets

(19)

(11) Numéro de publication: **0 384 835**
**A1**

(12) # DEMANDE DE BREVET EUROPEEN

(21) Numéro de dépôt: 90400468.6

(22) Date de dépôt: 21.02.90

(51) Int. Cl.5: **H01L 21/48, C04B 41/88**

(30) Priorité: 22.02.89 FR 8902278

(43) Date de publication de la demande:
**29.08.90 Bulletin 90/35**

(84) Etats contractants désignés:
**AT BE CH DE ES FR GB GR IT LI LU NL SE**

(71) Demandeur: **L'AIR LIQUIDE, SOCIETE**
**ANONYME POUR L'ETUDE ET**
**L'EXPLOITATION DES PROCEDES GEORGES**
**CLAUDE**
**75, Quai d'Orsay**
**F-75321 Paris Cédex 07(FR)**

(72) Inventeur: **Rotman, Frédéric**
**Teisan K.K., 9-1 Chinonome 1-chome,**
**Koto-ku**

**Tokyo 135(JP)**
Inventeur: **Rançon, Yannick**
**36, rue de Villacoublay**
**F-78140 Velizy(FR)**
Inventeur: **Queille, Phillippe**
**7, rue Rieussec**
**F-78220 Viroflay(FR)**
Inventeur: **Olivier, Michel**
**19, rue du Roussillon, Val des Quatre**
**Pignons**
**F-78650 Beynes(FR)**

(74) Mandataire: **Le Moenner, Gabriel et al**
**L'AIR LIQUIDE, Société Anonyme pour**
**l'etude et l'exploitation des procédés**
**Georges Claude 75, Quai d'Orsay**
**F-75321 Paris Cédex 07(FR)**

(54) **Procédé d'élaboration de composants multicouches céramique-métal et appareil pour sa mise en oeuvre.**

(57) L'invention concerne l'élaboration de composants multicouches céramiques-métal, selon lequel on procède, après mise en forme à l'état cru, notamment par métallisation et empilement de bandes céramiques crues prédécoupées, à une opération de cuisson simultanée, dite cocuisson, des composants sous une atmosphère à base d'hydrogène ou d'azote ou d'un mélange d'hydrogène et d'azote, à teneur régulée en vapeur d'eau, à une température d'abord comprise entre 800°C et 1800°C, et plus précisément soit à un palier de température moyennement élevée comprise entre 800°C et 1300°C pour certains matériaux céramiques telle la cordiérite et métalliques tels le cuivre et le nickel, soit à un palier de température compris entre environ 1400°C et 1800°C pour des matériaux réfractaires tels le tungstène, le molybdène, l'alumine, selon lequel l'atmosphère à teneur en vapeur d'eau est obtenue par apport à un gaz vecteur en (13) et (14) d'une quantité d'oxygène d'appoint (15), et d'une quantité d'hydrogène additionnelle en (14), suffisante pour obtenir par réaction d'oxydation de l'hydrogène la teneur prédéterminée en vapeur d'eau, et en ce qu'on détermine ces quantités d'appoint d'oxygène et le cas échéant additionnelle d'hydrogène pour que ladite teneur en eau soit, au cours de la cocuisson, celle qui est la plus appropriée aux différentes phases de ladite cocuisson.

Fig.1

Fig.2

Fig.3

Fig.4

La présente invention concerne un procédé d'élaboration de composants multicouches céramique-métal, selon lequel on procède, après mise en forme du composant à l'état cru, notamment par métallisation et empilement de bandes céramiques crues pré-découpées, à la cuisson simultanée, dite "cocuisson" des multicouches céramique-métal sous une atmosphère à point de rosée contrôlé.

La technologie "multicouches" prend une importance croissante dans le domaine des composants céramiques pour l'électronique. Elle est largement utilisée pour l'élaboration de composants passifs tels les condensateurs, les boîtiers d'encapsulation de circuits intégrés et les substrats d'interconnexion de circuits hybrides. Cette technologie peut sommairement être décomposée en trois étapes :
- le coulage à partir d'une barbotine et séchage de la céramique sous forme de bandes dont l'épaisseur est généralement comprise entre 20 et 200 microns ;
- la mise en forme du composant à l'état cru essentiellement par une métallisation et un empilement des couches céramiques : la métallisation de bandes céramiques pré-découpées est obtenue par dépôt, notamment par sérigraphie, d'une encre dont le constituant principal est une poudre métallique, de manière à réaliser les électrodes des condensateurs, les pistes électriques des boîtiers d'encapsulation et des substrats d'interconnexion (dans ces deux derniers cas, il faut inclure des opérations de perforation de certaines des bandes céramiques et de métallisation des "vias" ainsi obtenus) ; l'empilement des couches métallisées, suivi d'un pressage à chaud (environ 150° C), conduit au composant à l'état cru et sec, avec une structure similaire à celle qu'il aura après cuisson ;
- la cocuisson des composants crus.

La cocuisson, parfois également désignée sous l'expression "cofrittage", est une opération complexe de traitement thermique à plusieurs phases successives, au cours desquelles on cherche à effectuer :
- l'élimination des produits organiques contenus dans les "crus" ;
- le cofrittage proprement dit des couches céramiques et métalliques.

L'élimination des produits organiques qui doit être aussi complète que possible est effectuée de façon progressive pendant la montée en température. Le cofrittage est réalisé par mise en palier de la température à une valeur qui est fonction des matériaux à traiter et qui est généralement comprise entre environ 800 et environ 1800° C. La cocuisson est obtenue à basse température (de 800° C environ à 1300° C environ) pour des matériaux céramiques telle la cordiérite et métalliques tels le cuivre et le nickel, alors qu'elle est réalisée à haute température (de 1400° C environ à 1800° C environ) pour des matériaux réfractaires tels le tungstène, le molybdène, l'alumine, le nitrure d'aluminium. Pendant la cocuisson, une densification du composant se produit avec des retraits linéaires pouvant atteindre 20 % à 30 %. Selon les cas, des réactions d'interface céramique-métal importantes peuvent également se produire. Le traitement se termine par un refroidissement jusqu'à la température ambiante.

Cette technologie "multicouches" bien connue est en particulier décrite pour des matériaux réfractaires par B. SCHWARTZ et D.L. WILCOX dans la communication intitulée "Laminated Ceramics" paru dans "Proc. Electron Comp. Conf.", WASHINGTON, D.C. 1967.

Pendant cette opération de traitement thermique, le rôle de l'atmosphère est essentiel. Au cours des premiers stades du traitement, l'atmosphère doit promouvoir et en tout cas permettre l'élimination complète des produits organiques contenus dans les crus. Aux stades ultérieurs du traitement, l'atmosphère permet de contrôler la taille des grains, la densification du composant, et d'agir sur les réactions d'interface céramique-métal. L'atmosphère est également choisie afin d'éviter d'oxyder certains matériaux employés. Il s'agit principalement pour les métaux, du tungstène, du molybdène, du cuivre, et pour les céramiques, des "non oxydes" tel le nitrure d'aluminium. Dans certains cas, l'atmosphère permet aussi de régénérer à plus haute température des métaux qui auraient subi une oxydation partielle lors de l'élimination des liants. Ces rôles de l'atmosphère sont obtenus en régulant au cours du traitement son potentiel d'oxydo-réduction. Un moyen simple consiste à utiliser un apport plus ou moins important de vapeur d'eau dans une atmosphère constituée d'hydrogène et d'un gaz inerte tel l'azote, le cas échéant, dans une atmosphère constituée seulement d'hydrogène, voire au contraire seulement d'un gaz inerte.

Les atmosphères de traitement qui entrent en jeu dans ces opérations de cocuisson doivent avoir des teneurs en vapeur d'eau bien déterminées puisque ces teneurs en vapeur d'eau interviennent aussi bien en tant que telles, qu'en relation dans un rapport avec la teneur en hydrogène, de façon à conférer au gaz un effet oxydant, un effet réducteur, un effet neutre.

L'obtention des atmosphères humides pour la cocuisson de multicouches céramique-métal est actuellement assurée par simple barbotage du gaz dans un récipient contenant de l'eau. Cependant, cette façon de faire présente les inconvénients d'imposer un point de rosée à peu près égal à la température ambiante, et des fluctuations du point de rosée par variation de la température ambiante et du niveau d'eau dans le barboteur. Pour obtenir des points de rosée supérieurs à la température ambiante, on doit alors chauffer l'eau du barboteur et si l'on veut, au contraire, obtenir des points de rosée inférieurs à la température ambiante, on doit refroidir l'eau du barboteur ou diluer le gaz saturé en eau par un gaz sec. D'autre part pour obtenir un point de rosée bien fixé, on doit actuellement non seulement réguler la température de l'eau du barboteur, donc mettre en oeuvre des bains thermiquement isolés et thermostatés, mais on doit également réguler le niveau d'eau, donc mettre en oeuvre une sonde de niveau couplée à un dispositif automatique de remplissage. Un agencement de ce type s'avère coûteux, mais en outre, malgré tous ces perfectionnements, il subsiste encore différents inconvénients :

- d'une part la valeur du point de rosée engendrée est fonction de la géométrie du barboteur (en particulier de la surface d'échange eau/gaz), d'où l'obligation de déterminer par étalonnage les conditions opératoires de chaque barboteur (chauffage et dilution) afin d'obtenir les point de rosée désirés.

- d'autre part, dans le cas où l'on désire changer de point de rosée pour passer à un point de rosée supérieur, ce changement obtenu par chauffage du bain présente l'inconvénient d'avoir un temps de réponse long.

- enfin, dans le cas où l'on désire passer à un point de rosée inférieur, le refroidissement du bain présente le même inconvénient d'inertie thermique que ci-dessus, tandis que la dilution présente l'inconvénient d'un changement du débit total lors du passage d'un point de rosée à l'autre.

Ces inconvénients peuvent certes être écartés par une extension quasi-infinie de la surface d'échange eau/gaz par traversée, par exemple, d'un grand volume de matière poreuse comme décrit dans 3l'article intitulé "Advanced gas Moisturizing System for Ceramic processing applications" par F. W. GIACOBBE, paru dans "American Ceramic Society Bulletin", Volume 66, n° 10, 1987. et par conservation du débit total par réajustement des débits de gaz humidifié et de gaz sec.

Cependant, un tel dispositif d'humidification reste encore peu souple. Sa réalisation est très onéreuse et le problème de l'inertie thermique, dans le cas où l'on désire changer la température du bain, n'est toujours par résolu.

La présente invention a pour objet de disposer d'un matériel à fonctions plus performantes qui soit simple, souple et peu onéreux. En outre, elle permet de répondre à l'attente de procédés nécessitant des atmosphères à points de rosée à la fois contrôlés et évolutifs, particulièrement nécessaires dans la technique de cocuisson céramique-métal.

Le procédé de cocuisson de composants multicouches céramique-métal selon l'invention est caractérisé en ce que l'atmosphère à teneur en vapeur d'eau est obtenue par apport audit gaz vecteur d'une quantité d'oxygène d'appoint et d'une quantité d'hydrogène le cas échéant additionnelle, suffisante pour obtenir par réaction catalytique d'oxydation de l'hydrogène ladite teneur prédéterminée en vapeur d'eau, et en ce que, le cas échéant, on régule ces quantités d'appoint d'oxygène et le cas échéant additionnelle d'hydrogène pour que ladite teneur en eau soit, au cours de la cocuisson, celle qui est la plus adaptée aux différentes phases de ladite cocuisson.

La demanderesse a bien conscience que le principe intrinsèque de réalisation par catalyse d'une teneur en vapeur d'eau dans un gaz a déjà été proposé, notamment dans l'article intitulé "Réduction d'oxyde de fer par hydrogène pur" par L. GUILLET, M. EUDIER et Ph. POUPEAU paru dans "Mémoires Scientifiques Revue Métallurgique" n° 7/8 1967 où l'on propose d'employer, dans une étude de réduction de protoxyde de fer, soit de l'hydrogène pur, soit des mélange d'hydrogène, de vapeur d'eau et d'argon.

Cependant, la Demanderesse constate que, malgré la connaissance largement répandue de la réaction chimique concernée et de la possibilité de la réaliser par réaction catalytique, aucune application à échelle industrielle à la cocuisson de composants multicouches céramiques-métal n'a été proposée à ce jour, malgré les difficultés d'obtention de telles atmosphères humides selon les techniques rappelées ci-dessus et malgré l'effet particulièrement attractif de la solution appliquée, selon l'invention, dans la technique en question, où la reproductibilité et la précision des conditions opératoires de fabrication sont primordiales, et malgré les avantages d'une variation optimale de la teneur en vapeur d'eau en cours de l'opération de cocuisson.

Le catalyseur utilisé dans le procédé selon l'invention est choisi de façon à permettre une réaction immédiate et complète de l'oxygène et cela à température ambiante, avec une teneur résiduelle en oxygène inférieure à 10 vpm. Un catalyseur qui peut être utilisé est du type palladium sur support alumine qui peut traiter un débit horaire jusqu'à environ 5 000 à 10 000 fois le volume de réacteur. Ce type de catalyseur ne nécessite généralement aucun chauffage préalable du gaz et en outre n'implique pas une séquence de démarrage du réacteur avec rejet initial de gaz à l'air libre.

Dans une application prévue pour l'élaboration de composants multicouches céramique-métal, où le métal est du tungstène et/ou du molybdène et la céramique essentiellement de l'alumine, l'atmosphère de traitement a une teneur en vapeur d'eau comprise entre 2,5 % et 8 % et une teneur en hydrogène comprise entre 25 % et 75 %, avec un rapport teneur en hydrogène/teneur en vapeur d'eau compris entre 5 et 15.

Selon une variante de mise en oeuvre de cette même application sus-mentionnée, dans une première étape se terminant à la fin de la cocuisson, l'atmosphère de traitement a une teneur en vapeur d'eau comprise entre 5 % et 8 % et un rapport de la teneur en hydrogène à la teneur en vapeur d'eau compris entre 5 % et 10 %, et dans une seconde étape qui englobe le refroidissement, l'atmosphère de traitement a une teneur en hydrogène comprise entre 10 % et 75 % et un rapport de la teneur en hydrogène à la teneur en vapeur d'eau supérieur à 10 %.

Dans une autre application prévue pour l'élaboration de composants multicouches céramique-métal où le métal est du cuivre et la céramique est un composite verre-céramique ou de la cordiérite, dans une première étape se terminant à la fin de la cocuisson, l'atmosphère de traitement a une teneur en vapeur d'eau comprise entre 2,5 % et 8 % et une teneur en hydrogène comprise entre 0 % et 30 %, et dans une seconde étape qui englobe le refroidissement le rapport de la teneur en hydrogène à la teneur en vapeur d'eau est supérieur à 15 % et la teneur en hydrogène est supérieure à celle de ladite première étape.

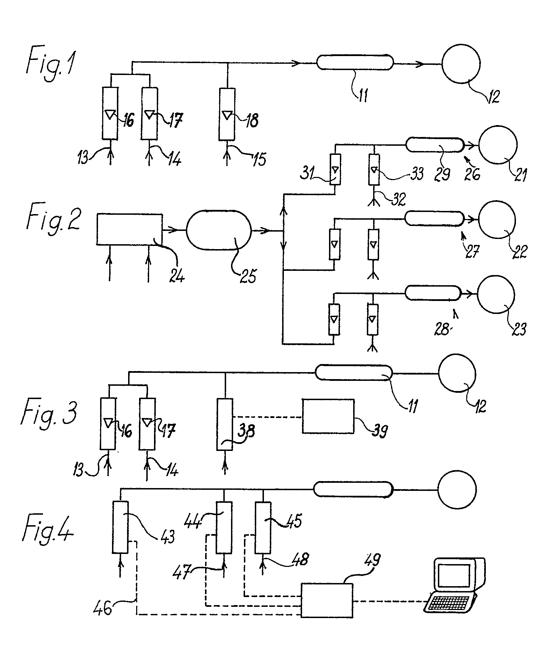

Les caractéristiques et avantages de l'invention ressortiront de la description qui suit, à titre d'exemple, en référence aux figures 1 à 4 qui représentent schématiquement quatre formes de réalisation de l'invention.

La figure 1 représente une forme de mise en oeuvre simplifiée où les trois constituants gazeux azote (N₂), hydrogène (H₂), oxygène (O₂) sont acheminés vers une chambre catalytique 11 et de là vers un four 12 via des conduites d'apport 13 pour l'azote, 14 pour l'hydrogène, 15 pour l'oxygène, chaque conduite 13, 14 et 15 incorporant un débitmètre à flotteur 16-17-18 équipé d'une vanne de réglage qui permet d'ajuster le débit. On assure ainsi, par un simple réglage des débits, une facile mise en oeuvre de points de rosée supérieurs ou inférieurs à la température ambiante.

Selon la figure 2 qui concerne une alimentation commune pour plusieurs fours 21, 22, 23, ... un prémélange d'azote (N₂), d'hydrogène (H₂), est d'abord réalisé dans un mélangeur 24 pour ensuite être acheminé vers plusieurs postes d'utilisation après passage dans une capacité-tampon commune 25. Chaque ligne de distribution 26, 27, 28, ... comprend :
- un débitmètre 31 pour le réglage du débit du mélange d'azote (N₂) et d'hydrogène (H₂) ;
- une conduite d'apport 32 à un débitmètre 33 pour le réglage du débit d'oxygène (O₂) ;
- une chambre catalytique 29 pour la génération de la vapeur d'eau.

On assure ainsi l'alimentation de plusieurs fours en parallèle et l'on peut, pour un mélange N₂/H₂ donné, mettre en oeuvre des points de rosée différents d'un four à l'autre.

Selon la figure 3 qui est une variante de la figure 1, où les mêmes éléments sont désignés par les mêmes chiffres de référence, on assure une plus grande stabilité du point de rosée par l'obtention d'un débit d'oxygène particulièrement stable, ce qui est atteint avec un appareil du type régulateur de débit massique 38 équipé d'une commande 39.

Selon la figure 4, on emploie trois régulateurs de débit massique 43, 44 et 45 dans les conduites d'azote 46, d'hydrogène 47 et d'oxygène 48, couplés à un dispositif 49 à commande informatique, permettant un pilotage dynamique du point de rosée par le biais d'un pilotage automatique des débits. On peut ainsi aisément programmer un profil de point de rosée simultanément avec un profil thermique tout en conservant un débit gazeux total constant.

On peut bien entendu envisager toute combinaison de ces différentes mises en oeuvre.

On donne maintenant ci-après un exemple de mise en oeuvre d'atmosphères appliquées à la cocuisson de composants multicouches céramique-métal :

EXEMPLE : Mise en oeuvre d'une atmosphère à point de rosée contrôlé et évolutif pour le cofrittage de substrats multicouches tungstène-alumine à 1600° C.

Afin de réaliser le cofrittage, on met en oeuvre le dispositif selon la figure 4 qui comprend des régulateurs de débit massique (précision égale à 1 % de la pleine échelle), car le rapport $H_2/H_2O$ est un paramètre critique de l'atmosphère de cocuisson. L'objectif est de générer un point de rosée évolutif en fonction du cycle de température, à savoir :

a) de la température ambiante à la fin du palier de cofrittage :
$H_2O = 5 \%$
$H_2 = 40 \%$
$N_2 = 55 \%$
$H_2/H_2O = 8$

b) pendant le refroidissement :
$H_2O = 2 \%$
$H_2 = 40 \%$
$N_2 = 58 \%$
$H_2/H_2O = 20$

Pendant le refroidissement, on rend l'atmosphère plus réductrice vis à vis du tungstène en augmentant le rapport $\dfrac{H_2}{H_2O}$.

La configuration du matériel selon la figure 4 permet d'engendrer facilement une telle séquence, grâce au pilotage des trois régulateurs de débit massique par ordinateur.

### Partie (a) du cycle

La teneur élevée en vapeur d'eau facilite l'élimination des liants. En outre, le rapport $H_2/H_2O$ peu élevé (choisi égal à 8) favorise la formation d'une structure dense de la céramique.

Les régulateurs de débit massique sont réglés de telle sorte qu'au mélange primaire :
$N_2 = 55,0 \% \pm 1,0 \%$
$H_2 = 45,0 \% \pm 1,0 \%$
$H_2O < 10$ ppm

On ajoute un courant d'oxygène égal à
$O_2 = 2,50 \% \pm 0,05 \%$
(en pourcentage du débit $N_2 + H_2$),
pour obtenir après passage dans la chambre catalytique le mélange suivant (proportions calculées) :
$N_2 = 55,0 \% \pm 1,1 \%$
$H_2 = 40,0 \% \pm 1,1 \%$
$H_2O = 5,0 \% \pm 0,2 \%$
$O_2 = 0 \%$

Au niveau d'un piquage de contrôle en entrée de la chambre catalytique on a analysé la teneur en vapeur d'eau du mélange $N_2$ -$H_2$ - $O_2$ avant la réaction catalytique et on a mesuré un point de rosée inférieur à - 60° C (10 ppm).

De même, au moyen d'un piquage de contrôle en sortie de la chambre catalytique on a analysé le mélange gazeux après réaction catalytique afin de vérifier la teneur des différents constituants. La teneur en hydrogène a été évaluée par un chromatographe, la teneur en vapeur d'eau par un hygromètre à miroir refroidi, tandis que la teneur en oxygène a été mesurée à l'aide d'un analyseur à cellule électrolytique.

Les proportions ainsi mesurées sont :
$H_2 = 39,6 \% \pm 0,2 \%$
$H_2O = 5,08 \% \pm 0,06 \%$
$O_2 < 5$ ppm

Compte tenu des incertitudes expérimentales, les teneurs mesurées sont tout à fait conformes aux teneurs calculées. Ceci illustre bien la facilité de mise en oeuvre par simple réglage des débits et le fait qu'aucun étalonnage n'est alors nécessaire.

### Partie (b) du cycle :

En fin de palier de température de cofrittage, de nouveaux débits sont affichés sur les régulateurs de débit massique afin d'éviter d'oxyder le tungstène pendant le refroidissement. Ceci est obtenu en augmentant le rapport teneur en hydrogène/teneur en vapeur d'eau au moyen d'une diminution de la teneur en vapeur d'eau du mélange.

Les régulateur de débit massique sont réglés de façon qu'au mélange primaire :
$N_2 = 58,0 \% \pm 1,0 \%$
$H_2 = 42,0 \% \pm 1,0 \%$
on ajoute un courant d'oxygène égal à
$O_2 = 1,00 \% \pm 0,02 \%$
(en pourcentage du débit $N_2 + H_2$)
afin d'obtenir après passage dans la chambre catalytique le mélange suivant (teneurs calculées) :
$N_2 = 58,0 \% \pm 1,0 \%$
$H_2 = 40,0 \% \pm 1,0 \%$
$H_2O = 2,00 \% \pm 0,06 \%$

Or, vérification faite, le point de rosée du mélange avant passage dans la chambre catalytique est inférieur à - 60° C (10 ppm), et les teneurs mesurées expérimentalement en sortie de la chambre sont :
$H_2 = 39,7 \% \pm 0,2 \%$
$H_2O = 1,96 \% \pm 0,03$ %
$O_2 < 5$ ppm

Les teneurs mesurées sont à nouveau tout à fait conformes aux teneurs calculées, en prenant en compte les incertitudes expérimentales.

Cet exemple illustre bien l'intérêt de l'invention pour le pilotage dynamique du point de rosée au cours du traitement.

## Revendications

1. Procédé d'élaboration de composants multicouches céramique-métal, selon lequel on procède, après mise en forme à l'état cru, notamment par métallisation et empilement de bandes céramiques crues pré-découpées, à une opération de cuisson simultanée, dite cocuisson, des composants sous une atmosphère à teneur en vapeur d'eau, élaborée à partir d'un gaz vecteur formé d'hydrogène ou d'azote ou d'un mélange d'hydrogène et d'azote, avec montée en température jusqu'à un palier compris entre environ 800° C et environ 1800° C, et plus précisément, soit avec un palier à une température moyennement élevée comprise entre environ 800° C et environ 1300° C pour certains matériaux céramiques telle la cordiérite et pour certains matériaux métalliques tels le cuivre et le nickel, soit avec un palier à haute température compris entre environ 1400° C et environ 1800° C pour des matériaux réfractaires tels le tungstène, le molybdène, l'alumine, le nitrure d'aluminium caractérisé en ce que, afin d'assurer une teneur en vapeur d'eau comprise entre 1 % et 8 % dans l'atmosphère à teneur en vapeur d'eau, on apporte au dit gaz vecteur une quantité d'oxygène d'appoint et une quantité d'hydrogène le cas échéant additionnelle, suffisante pour obtenir, de façon connue en soi, par réaction catalytique d'oxydation de l'hydrogène ladite teneur prédéterminée en vapeur d'eau, et en ce qu'on détermine ces quantités d'appoint d'oxygène et le cas échéant additionnelle d'hydrogène pour que ladite teneur en eau soit, au cours de la cocuisson, celle qui est la plus adaptée aux différentes phases de ladite cocuisson.

2. Procédé selon la revendication 1, caractérisé en ce que l'oxygène d'appoint est initialement présent dans l'azote, qui est de l'azote brut obtenu par séparation d'air par adsorption ou perméation.

3. Procédé selon la revendication 1 ou 2, caractérisé en ce que le catalyseur est du type à autonomie énergétique, notamment du type à palladium sur support d'alumine.

4. Procédé selon la revendication 1 ou 2, caractérisé en ce que, dans le cas de teneur en vapeur d'eau inférieure à 1 %, le catalyseur est associé à un moyen de chauffage.

5. Appareil pour la mise en oeuvre du procédé selon l'une quelconque des revendications 1 à 4, caractérisé en ce qu'il comprend une conduite de mélange, raccordée à l'amont à au moins deux conduites d'apport, le cas échéant à trois conduites d'apport à commande de débit, et à l'aval à un réacteur catalytique.

6. Appareil pour la mise en oeuvre du procédé selon la revendication 5, caractérisé en ce que la conduite de mélange incorpore un mélangeur raccordé à l'amont à au moins deux conduites individuelles.

7. Appareil pour la mise en oeuvre du procédé selon la revendication 5 ou 6, caractérisé en ce que la conduite de mélange se subdivise, en aval de la communication avec deux conduites d'apport, en une pluralité de conduites individuelles de mélange, dans chacune desquelles débouche la troisième conduite d'apport et qui sont raccordées chacune à un réacteur catalytique individuel.

8. Appareil pour la mise en oeuvre du procédé selon la revendication 5, 6 ou 7, caractérisé en ce qu'un régulateur de débit massique est incorporé à une ou plusieurs conduites d'apport à commande de débit.

9. Application du procédé selon les revendications 1 à 4 et de l'appareil selon les revendications 5 à 8 à l'élaboration de composants multicouches céramique-métal, où le métal est du tungstène et/ou du molybdène et la céramique essentiellement de l'alumine, caractérisée en ce que l'atmosphère de traitement a une teneur en vapeur d'eau comprise entre 2,5 % et 8 % et une teneur en hydrogène comprise entre 25 % et 75 %, avec un rapport de la teneur en hydrogène à la teneur en vapeur d'eau compris entre 5 et 15.

10. Application du procédé selon les revendications 1 à 4 et de l'appareil selon les revendications 5 à 8 à l'élaboration de composants multicouches céramique-métal, où le métal est du tungstène et/ou du molybdène et la céramique essentiellement de l'alumine, caractérisée en ce que dans une première étape se terminant à la fin de la cocuisson, l'atmosphère de traitement a une teneur en vapeur d'eau comprise entre 5 % et 8 % et un rapport de la teneur en hydrogène à la teneur en vapeur d'eau compris entre 5 et 10, et dans une seconde étape qui englobe le refroidissement l'atmosphère de traitement a une teneur en hydrogène comprise entre 10 % et 75 % et un rapport de la teneur en hydrogène à la teneur en vapeur d'eau supérieur à 10.

11. Application du procédé selon les revendications 1 à 4 et de l'appareil selon les revendications 5 à 8 à l'élaboration de composants multicouches céramique-métal, où le métal est du cuivre et la céramique est un composite verre-céramique ou de la cordiérite, caractérisée en ce que dans une première étape se terminant à la fin de la cocuisson, l'atmosphère de traitement a une teneur en vapeur d'eau comprise entre 2,5 % et 8 % et une teneur en hydrogène comprise entre 0 % et 30 %, et dans une seconde étape qui englobe le refroidissement le rapport de la teneur en hydrogène à la teneur en vapeur d'eau est supérieur à 15 et la teneur en hydrogène est supérieure à celle de ladite première étape.

Fig.1

Fig.2

Fig.3

Fig.4

Office européen des brevets

**RAPPORT DE RECHERCHE EUROPEENNE**

Numero de la demande

EP  90 40 0468

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,Y | MEMOIRES SCIENTIFIQUES DE LA REVUE DE METALLURGIE, vol. LXIV, nos. 7/8, 1967, pages 653-661; L. GUILLET et al.: "Réduction d'oxyde de fer par l'hydrogène pur" * Colonne 2, ligne 1 - colonne 3, ligne 51; colonne 16, lignes 31-37 * | 1,3,9-11 | H 01 L  21/48<br>C 04 B  41/88 |
| A | IDEM | 8 | |
| Y | SOLID-STATE TECHNOLOGY, vol. 29, no. 9, septembre 1986, pages 135-138, Port Washington, NY, US; E.A. HAYDUK, Jr. et al.: "Furnace atmosphere's effect on cofiring tungsten-alumina multilayer substrates" * Page 135, colonne 2 - page 136, ligne 12; page 136, ligne 54 - page 137, ligne 16 * | 1,3,9 | |
| Y | US-A-4 678 683  (PASCO et al.) * Revendications 1,2,11,12; colonne 6, lignes 34-52; colonne 7, lignes 20-64 * | 10 | DOMAINES TECHNIQUES RECHERCHES (Int. Cl.5) |
| Y | EP-A-0 267 602  (INTERNATIONAL BUSINESS MACHINES) * Colonne 4, ligne 13 - colonne 6, ligne 13; revendication 1 * | 11 | H 01 L  21<br>C 04 B  41<br>C 23 C   8 |
| A | | 5-7 | |
| A | EP-A-0 209 065  (DAINIPPON SCREEN MFG. CO., LTD) * Résumé; page 2, ligne 32 - page 3, ligne 19; page 4, ligne 31 - page 6, ligne 35 * | 1,3-6 | |

Le présent rapport a été établi pour toutes les revendications

| Lieu de la recherche | Date d'achèvement de la recherche | Examinateur |
|---|---|---|
| LA HAYE | 12-04-1990 | OLSSON S.A. |

EPO FORM 1503 03.82 (P0402)

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant